# DEMANDE DE BREVET EUROPEEN

(11) **EP 4 822 365 A1**
(43) Date de publication de la demande: **14.10.2026**
(21) Numéro de dépôt: 26170827.5
(22) Date de dépôt: 07.04.2026
(51) Int. Cl.: G01R 31/28

(54) **DISPOSITIF DE TEST ET PROCÉDÉ DE TEST DE DISPOSITIFS MICROÉLECTRONIQUES**

(30) Priorité: 10.04.2025 FR 2503813
(71) Demandeur: Commissariat à l'Energie Atomique et aux Energies Alternatives, 75015 Paris (FR)
(72) Inventeur: RENAUD, Pablo, 38054 GRENOBLE Cedex 9 (FR)
(74) Mandataire: Germain Maureau

(57) **Abrégé**

L'invention concerne un procédé de test pour tester des dispositifs microélectroniques (11) comprenant une étape de mise à disposition (E1) d'un substrat fonctionnel (10) présentant les dispositifs microélectroniques (11) présentant chacun au moins un premier plot de collage (13); une étape de fourniture (E2) d'un dispositif de test (40) comprenant des deuxièmes plots de collage (45) ; une étape de collage (E4), dans laquelle une liaison par collage temporaire est formée entre un premier plot de collage (13) et un deuxième plot de collage (45) ; et une étape de mesure (E5), dans laquelle une unité de mesure (2) détermine, pour chaque dispositif microélectronique (11), un état de fonctionnement.

L'invention concerne également un dispositif de test (40), pour mettre en œuvre un tel procédé de test.

## Description

### Domaine technique de l'invention

La présente invention concerne le domaine de la microélectronique, et plus particulièrement, un procédé de test pour tester des dispositifs microélectroniques.

L'invention concerne également un dispositif de test pour mettre en oeuvre un tel procédé de test.

### Etat de la technique

Dans le domaine de la microélectronique, la diminution des dimensions des dispositifs électroniques (ou puces) permet d'augmenter la densité de puces sur une même plaque. Afin d'augmenter davantage la densité de puces par unité de volume, il est par ailleurs connu de l'état de la technique de former des structures en 3D.

Quel que soit la structure choisie, il est fréquent de vouloir tester la fonctionnalité des puces entre différentes étapes du procédé de fabrication, pour ne pas réaliser des étapes de procédé sur une puce défectueuse.

Certains procédés de fabrication comportent notamment des étapes de transfert de puces entre un substrat de fabrication et un substrat final. Dans ce cas, il est préféré de réaliser un test de fonctionnement de chacune des puces avant leur transfert vers le substrat final. Cela est particulièrement pertinent dans le cas d'une structure en 3D, car il est primordial d'éviter d'empiler une puce fonctionnelle avec une puce dysfonctionnelle.

Pour cela, il est connu de l'état de la technique de réaliser des tests électriques au niveau de plots de contact des puces à tester. Ces tests électriques impliquent l'utilisation de pointes venant au contact des plots de contacts des puces.

Bien que cette méthode donne satisfaction en ce qu'elle permet de réaliser les tests électriques nécessaires, elle génère des marques au niveau des plots de contact qui peuvent être dommageables pour les étapes ultérieures du procédé. Il a ainsi été démontré qu'une topographie était induite par la réalisation des tests électriques au niveau des plots de contact.

Pour résoudre ces problèmes, il existe des méthodes de test non destructrices sans contact, basées sur l'utilisation d'un faisceau lumineux modulé pour irradier une puce et induire un courant électrique générant un champ magnétique. Ce champ magnétique peut ensuite être détectée par une interface de mesure, et un signal de différence de phase est extrait en comparant le champ magnétique au signal de référence. Il est ainsi possible de déterminer un état de fonctionnement d'une puce sans contact.

Toutefois, ces méthodes sans contact ne sont pas adaptées pour des procédés utilisés à l'échelle industrielle car la méthode de mesure est très couteuse, et qu'elle est difficile à mettre en œuvre pour tester simultanément une grande quantité de puces.

Il existe donc un besoin de trouver une méthode fiable, efficace et peu couteuse pour tester des puces de faible dimension, sans endommager les plots de contact de ces puces.

### Objet de l'invention

La présente invention a pour but de proposer une solution qui réponde à tout ou partie des problèmes précités.

Ce but peut être atteint grâce à la mise en œuvre d'un procédé de test pour tester des dispositifs microélectroniques, le procédé de test comprenant :
- une étape de mise à disposition d'un substrat fonctionnel présentant une face avant, le substrat fonctionnel comprenant en outre les dispositifs microélectroniques agencés du côté de ladite face avant, chaque dispositif microélectronique présentant au moins un premier plot de collage tourné du côté de la face avant, les premiers plots de collage étant agencés sur la face avant selon un premier agencement ordonné ;
- une étape de fourniture d'un dispositif de test présentant une face de collage, le dispositif de test comprenant des deuxièmes plots de collage agencés sur la face de collage selon un deuxième agencement ordonné, ledit deuxième agencement ordonné comprenant au moins une portion qui correspond au premier agencement ordonné, le dispositif de test comprenant en outre des éléments de liaison électriquement conducteurs, lesdits éléments de liaison étant configurés pour assurer une connexion électrique entre chaque deuxième plot de collage et des plots de test ;
- une étape de collage, dans laquelle la face de collage du dispositif de test est mise en contact avec la face avant du substrat fonctionnel, de sorte que, pour chaque dispositif microélectronique, une liaison par collage temporaire est formée entre un premier plot de collage et un deuxième plot de collage ;
- une étape de mesure, dans laquelle une unité de mesure détermine, pour chaque dispositif microélectronique, un état de fonctionnement, ladite étape de mesure étant mise en œuvre par l'application d'un courant ou d'une tension électrique à chaque premier plot de collage, par l'intermédiaire du deuxième plot de collage avec lequel ledit premier plot de collage est en contact, et du plot de test correspondant.

Les dispositions précédemment décrites permettent de proposer un procédé de test permettant de tester unitairement une pluralité de dispositifs microélectroniques disposés sur un substrat fonctionnel, lors d'une unique étape de mesure. L'utilisation d'un dispositif de test dédié au substrat fonctionnel à tester permet de réaliser la reprise de contact par collage temporaire, ce qui limite l'endommagement des premiers plots de collage.

Le procédé de test peut en outre présenter une ou plusieurs des caractéristiques suivantes, prises seules ou en combinaison.

Selon un mode de réalisation, lors de l'étape de fourniture, le deuxième agencement ordonné est mirroré/chiral par rapport au premier agencement ordonné.

De cette manière, il est possible de garantir qu'il existe un deuxième plot de collage qui corresponde à un premier plot de collage pour chacun des dispositifs microélectroniques à tester.

Selon un mode de réalisation, les deuxièmes plots de collage sont agencés sur la face de collage du dispositif de test selon le premier agencement ordonné.

Selon un mode de réalisation, le procédé de test comprend en outre, une étape de polissage mise en œuvre avant l'étape de collage, dans laquelle au moins une face choisie parmi la face avant du substrat fonctionnel et la face de collage du dispositif de test est polie par polissage mécano-chimique.

De cette manière, il est possible de s'assurer que les premiers ou deuxièmes plots de collage présentent une rugosité suffisamment faible pour améliorer le collage temporaire entre eux.

De manière avantageuse, l'étape de polissage comprend le polissage mécanochimique de la face de collage du dispositif de test et le polissage de la face avant du substrat fonctionnel. Ainsi, l'efficacité du collage entre les premiers plots de collage et les deuxièmes plots de collage est maximisée lors de l'étape de collage.

Selon un mode de réalisation, l'étape de collage est mise en œuvre par un collage hybride entre les premiers plots de collage et les deuxièmes plots de collage.

De cette manière, il est possible de réaliser simplement l'étape de collage, ce qui est particulièrement adapté pour un procédé de test mis en œuvre dans un procédé de fabrication de dispositifs microélectroniques.

Par « collage hybride », on entend la formation d'une liaison spontanée et directe entre deux surfaces polies comprenant chacune au moins un plot métallique (par exemple en cuivre), entouré par une couche de matériau diélectrique (par exemple un oxyde de silicium). En effet, le collage hybride en microélectronique est une technique d'intégration 3D permettant l'assemblage direct de composants en mettant en contact deux surfaces hybrides composées d'un motif métallique intégré dans une matrice diélectrique (par exemple un motif en cuivre (Cu) intégré dans une matrice d'oxyde de silicium (SiO₂)). Après polissage et alignement, ces surfaces sont alignées et mises en contact pour former un collage simultané métal-métal et diélectrique-diélectrique, assurant une tenue mécanique et une connexion électrique.

Selon un mode de réalisation, l'étape de collage est mise en œuvre par liaison directe hydrophile entre les premiers plots de collage et les deuxièmes plots de collage uniquement.

De cette manière, il est possible de réaliser simplement l'étape de collage selon une deuxième alternative particulièrement adaptée pour un procédé de test mis en œuvre dans un procédé de fabrication de dispositifs microélectroniques.

Par « liaison directe hydrophile entre les premiers plots de collage et les deuxièmes plots de collage uniquement », on entend la formation d'une liaison spontanée et directe entre deux surfaces polies comprenant chacune au moins un plot métallique, entouré par de l'air.

Par exemple, la mise en œuvre d'une telle liaison directe hydrophile en l'absence d'une couche de matériau diélectrique est décrite dans le document Candice Thomas et al 2025 Mater. Quantum. Technol. 5 016001*,* ou dans le document *Pablo Renaud et al. DOI: 10.1109*/*ECTC51529.2024.00076.*

Selon un mode de réalisation, le procédé de test comprend en outre une étape de détachement, dans laquelle une fine lame est introduite entre la face avant du substrat fonctionnel et la face de collage du dispositif de test, de manière à rompre la liaison formée entre les premiers plots de collage et les deuxièmes plots de collage lors de l'étape de collage.

De cette manière, il est possible de retirer le dispositif de test du contact du substrat fonctionnel, pour mettre en œuvre des éventuelles étapes ultérieures de fabrication, comprenant le substrat fonctionnel.

De manière générale, par « fine lame », on entend une lame présentant une épaisseur négligeable par rapport à sa longueur et sa largeur. Dans le cas de la présente invention, on entend par exemple que cette épaisseur est comprise entre 0,1 mm et 1,0 mm.

Selon un mode de réalisation, lors de l'étape de mise à disposition, l'agencement des premiers plots de collage selon le premier agencement ordonné est réalisé par photolithographie au moyen d'un masque de fabrication, et lors de l'étape de fourniture du dispositif de test, l'agencement des deuxièmes plots de collage selon le deuxième agencement ordonné est réalisé par photolithographie au moyen dudit masque de fabrication.

Ainsi, il est possible de garantir que le premier agencement ordonné est identique au deuxième agencement ordonné, par l'utilisation d'un seul masque de fabrication. Le procédé est ainsi plus répétable et moins couteux.

Selon un mode de réalisation, lors de l'étape de collage, la face de collage du dispositif de test recouvre la face avant du substrat fonctionnel sur au moins 80% de ladite face avant.

De cette manière, il est possible d'utiliser un unique dispositif de test pour réaliser des tests électriques sur une majorité ou une totalité des dispositifs microélectroniques, en une seule étape de test.

Selon un mode de réalisation, la face avant du substrat fonctionnel présente une forme de disque présentant un premier rayon, et dans lequel la face de collage du dispositif de test présente une forme de disque présentant un deuxième rayon égal au premier rayon, l'étape de collage étant alors mise en œuvre par un recouvrement total de la face avant du substrat fonctionnel par la face de collage du dispositif de test.

De cette manière, il est possible de garantir que la totalité des dispositifs microélectroniques sont collés à la face de collage, ce qui permet de maximiser le nombre de dispositifs microélectroniques testés, en une seule étape de test.

La présente demande décrit également un dispositif de test adapté pour mettre en œuvre un procédé de test tel que décrit précédemment, pour tester des dispositifs microélectroniques agencés sur la face avant d'un substrat fonctionnel, où chaque dispositif microélectronique présente au moins un premier plot de collage tourné du côté de la face avant, et où les premiers plots de collage sont agencés sur la face avant selon un premier agencement ordonné ; le dispositif de test comprenant :
- un support présentant une face de collage et une interface de connexion ;
- des deuxièmes plots de collage agencés sur la face de collage selon un deuxième agencement ordonné comprenant au moins une portion qui correspond au premier agencement ordonné ;
- des éléments de liaison électriquement conducteurs, lesdits éléments de liaison étant destinés à assurer une connexion électrique entre chaque deuxième plot de collage et une unité de mesure externe, ladite connexion électrique avec l'unité de mesure externe étant réalisée au niveau de plots de test disposés au niveau de l'interface de connexion.

Les dispositions précédemment décrites permettent de proposer un dispositif de test apte à mettre en œuvre le procédé de test, sans endommager les premiers plots de collage des dispositifs microélectroniques. Il est ainsi possible de réaliser un test non destructif d'un ensemble de dispositifs microélectroniques en une seule étape, et sans risque de détériorer les dispositifs microélectroniques.

Le dispositif de test peut en outre présenter une ou plusieurs des caractéristiques suivantes, prises seules ou en combinaison.

Selon un mode de réalisation, l'interface de connexion est disposée sur une face de test opposée à la face de collage, et les éléments de liaison traversent le support entre les deuxièmes plots de collage, et les plots de test.

Ainsi, la reprise de contact des éléments de liaison est réalisée du côté opposé à celui au niveau duquel les deuxièmes plots de collage sont en contact avec les premiers plots de collage. La mise en œuvre du procédé de fabrication est ainsi plus facile.

Par exemple, les éléments de liaison comprennent des TSV, de l'anglais Through Silicon Vias.

Selon un mode de réalisation, l'interface de connexion est disposée du côté de la face de collage, sur une zone périphérique agencée autour des deuxièmes plots de collage.

Ainsi, il est possible de reprendre le contact électrique sur les plots de test au niveau de la face de collage directement, et à l'extérieur d'une zone centrale de la face de collage au niveau de laquelle est réalisée le collage.

Selon un mode de réalisation, les deuxièmes plots de collage comprennent du cuivre.

De cette manière, la mise oeuvre d'une étape de collage par collage hybride est facilitée.

Selon un mode de réalisation, les deuxièmes plots de collage comprennent du niobium.

Ainsi, la mise oeuvre d'une étape de collage par liaison directe hydrophile, en l'absence d'une matrice diélectrique est facilitée.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue schématique des étapes de mise à disposition, de fourniture et de polissage selon un premier mode de réalisation de l'invention.
La figure 2 est une vue schématique des étapes de mise à disposition, de fourniture et de polissage selon un deuxième mode de réalisation de l'invention.
La figure 3 est une vue schématique de l'étape de collage selon un mode de réalisation de l'invention.
La figure 4 est une vue schématique de l'étape de mesure selon un mode de réalisation de l'invention.
La figure 5 est une vue schématique de l'étape de détachement selon un mode de réalisation de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

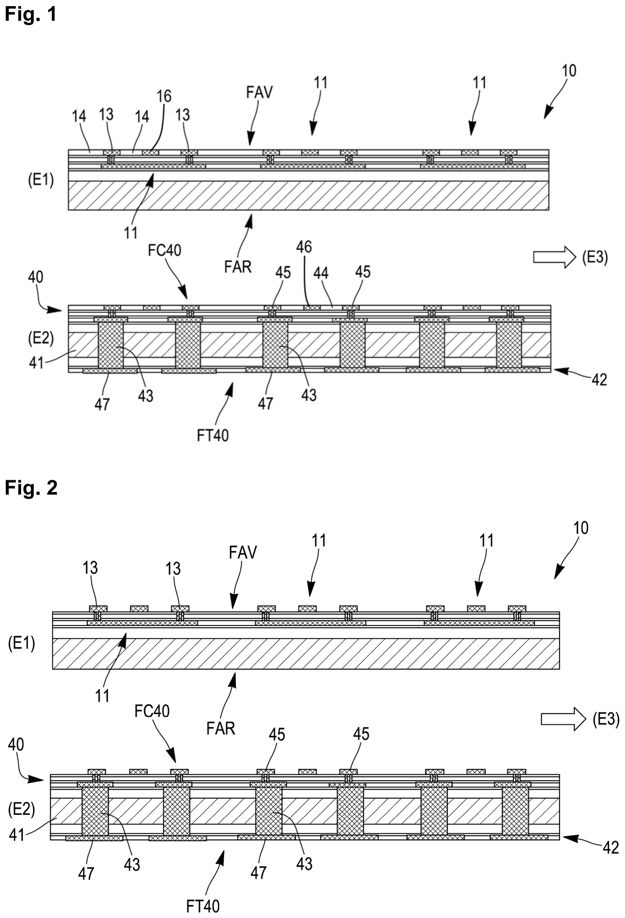

Comme on peut le voir sur les figures 1 à 5, l'invention concerne un procédé de test pour tester des dispositifs microélectroniques 11, généralement micrométriques. En effet, lesdits dispositifs microélectroniques 11 peuvent présenter des dimensions dans le plan de la plaque de support allant jusqu'à quelques millimètres, et peuvent présenter une épaisseur comptée perpendiculairement audit plan, allant jusqu'à quelques centaines de micromètres.

Comme cela est illustré sur les figures 1 et 2, l'invention comprend tout d'abord une étape de mise à disposition E1 d'un substrat fonctionnel 10. Ce substrat fonctionnel 10 présente une face avant FAV et une face arrière FAR, opposée à la face avant FAV. Généralement, le substrat fonctionnel 10 se présente sous une forme de plaque en forme de disque, appelée également « wafer » en anglais, selon la terminologie admise dans le domaine de la microélectronique. Ainsi, la face avant FAV du substrat fonctionnel 10 présente également une forme de disque présentant un premier rayon.

Le substrat fonctionnel 10 comprend les dispositifs microélectroniques 11 agencés du côté de ladite face avant FAV, par exemple agencés sur ladite face avant FAV. Les dispositifs microélectroniques 11 résultent généralement d'un empilement de couches de matériaux au niveau de la face avant, lesdites couches étant déposées selon un motif dédié, par exemple par un procédé de photolithographie. Les figures 1 et 2 illustrent deux modes de réalisation différents, et non-limitatifs, dans lesquels le substrat fonctionnel 10 comprend trois dispositifs microélectroniques 11 disposés au niveau de la face avant FAV. Un substrat fonctionnel 10 utilisé dans l'industrie de la microélectronique comprend cependant généralement une grande quantité de dispositifs microélectroniques 11 disposés sur la face avant FAV. Par exemple, les dispositifs microélectroniques 11 sont répartis sur la face avant FAV selon une répartition matricielle, ladite répartition matricielle étant généralement définie par le masque d'insolation utilisé dans le procédé de photolithographie. Compte-tenu du fait que certains éléments sont représentés plusieurs fois sur les figures, les références numériques n'ont pas nécessairement été reportées pour tous les éléments afin de faciliter la lecture des figures.

Chaque dispositif microélectronique 11 à tester par le procédé de test présente au moins un premier plot de collage 13 tourné du côté de la face avant FAV. Généralement, les dispositifs microélectroniques 11 comprennent au moins deux ou trois premiers plots de collage 13, afin de correspondre au moins aux bornes électriques des dispositifs microélectroniques 11. Comme cela est illustré sur la figure 1, les dispositifs microélectroniques présentent deux premiers plots de collage 13 visibles. Ces deux premiers plots de collage 13 sont configurés à la fois pour correspondre aux bornes électrique du dispositif microélectronique 11, et pour permettre le collage avec un dispositif de test 40 qui sera décrit plus loin. Le substrat fonctionnel 10 peut également comprendre, au moins un premier plot de collage non fonctionnel 16, configuré pour améliorer le collage avec le dispositif de test 40. Ce premier plot de collage non fonctionnel 16 ne contribue donc pas à l'interconnexion électrique avec le dispositif de test 40. Par exemple, il est possible qu'un ou plusieurs premiers plots de collage non fonctionnel 16 soient prévus pour chaque dispositif microélectronique 11 à tester, afin d'améliorer le collage avec le dispositif de test 40 (et notamment avec des deuxièmes plots de collage non fonctionnels 46 du dispositif de test).

L'ensemble des premiers plots de collage 13 sont agencés sur la face avant FAV selon un premier agencement ordonné. Par exemple, ledit premier agencement ordonné comprend une organisation matricielle correspondant à la répartition matricielle des dispositifs microélectroniques 11 sur la face avant FAV du substrat fonctionnel 10.

Plus précisément, l'agencement des premiers plots de collage 13 selon le premier agencement ordonné peut résulter d'une étape de photolithographie réalisée au moyen d'un masque de fabrication.

Selon le premier mode de réalisation représenté sur la figure 1, les premiers plots de collage 13 comprennent un plot métallique, par exemple en cuivre, entouré par une couche de matériau diélectrique 14, par exemple un oxyde de silicium. Selon cet exemple, les premiers plots de collage 13 sont ainsi intégré dans la matrice diélectrique selon le premier agencement ordonné.

Selon le deuxième mode de réalisation représenté sur la figure 2, les premiers plots de collage 13 comprennent un plot métallique, par exemple en niobium, entouré par de l'air.

Dans ces deux modes de réalisation, les premiers plots de collage 13 sont tournés vers l'extérieur du substrat fonctionnel 10, afin de présenter extérieurement une surface servant à réaliser un collage qui sera décrit plus loin.

Le procédé de test comprend également une étape de fourniture E2 d'un dispositif de test 40.Le dispositif de test 40 se présente également sous une forme de plaque en forme de disque, et présente une face de collage FC40. La face de collage FC40 présente également une forme de disque présentant un deuxième rayon supérieur à 80% du premier rayon, et peut être égal au premier rayon de la face avant FAV.

Le dispositif de test 40 comprend un support 41 présentant la face de collage FC40 et une interface de connexion 42, ainsi que des deuxièmes plots de collage 45 agencés sur la face de collage FC40 selon un deuxième agencement ordonné comprenant au moins une portion qui correspond au premier agencement ordonné. Il est ainsi possible de garantir, sur cette portion, que des premiers plots de collage 13 puissent être collés avec des deuxièmes plots de collage 45. Cette portion de correspondance entre le premier agencement ordonné et le deuxième agencement ordonné peut être continue, ou discontinue.

Comme cela est illustré sur la figure 1, le dispositif de test 40 peut également comprendre, au moins un deuxième plot de collage non fonctionnel 46, configuré pour améliorer le collage avec le substrat fonctionnel 10, et notamment avec les premiers plots de collage non fonctionnel 16. Ce deuxième plot de collage non fonctionnel 46 ne contribue donc pas à l'interconnexion électrique avec le substrat fonctionnel 10. Il est avantageux de prévoir que le deuxième agencement ordonné soit chiral par rapport au premier agencement ordonné, par exemple que le deuxième agencement ordonné soit l'image du premier agencement ordonné par rapport à un miroir plan. De cette manière, il est possible de garantir qu'il existe un deuxième plot de collage 45 qui corresponde à un premier plot de collage 13 pour chacun des dispositifs microélectroniques 11 à tester. Par exemple, les deuxièmes plots de collage 45 peuvent être agencés sur la face de collage FC40 du dispositif de test 40 selon le premier agencement ordonné.

Avantageusement, lors de l'étape de fourniture E2 du dispositif de test 40, l'agencement des deuxièmes plots de collage 45 selon le deuxième agencement ordonné peut être réalisé par photolithographie au moyen du même masque de fabrication que celui qui a été utilisé pour l'agencement des premiers plots de collage 13 selon le premier agencement ordonné. Ainsi, il est possible de garantir que le premier agencement ordonné est identique au deuxième agencement ordonné, par l'utilisation d'un seul masque de fabrication. Le procédé est ainsi plus répétable et moins couteux.

Suivant le type de collage qui sera réalisé lors d'une étape de collage E4 ultérieure, il est possible d'adapter la nature et l'environnement des deuxièmes plots de collage 45 à la surface de la face de contact FC40. Selon une première variante illustrée sur la figure 1 les deuxièmes plots de collage 45 comprennent du cuivre, par exemple intégrés et entourés dans une matrice diélectrique 44. De cette manière, la mise œuvre d'une étape de collage E4 par collage hybride est facilitée. Selon une deuxième variante illustrée sur la figure 2, les deuxièmes plots de collage 45 comprennent du niobium, par exemple entourés par de l'air. Ainsi, la mise œuvre d'une étape de collage E4 par liaison directe hydrophile, en l'absence d'une matrice diélectrique 44 est facilitée.

Le dispositif de test 40 comprend en outre des éléments de liaison 43 électriquement conducteurs, lesdits éléments de liaison 43 étant configurés pour assurer une connexion électrique entre chaque deuxième plot de collage 45 et des plots de test 47. Comme cela sera décrit en référence à l'étape de mesure E5, lesdits éléments de liaison 43 peuvent être destinés à assurer une connexion électrique entre chaque deuxième plot de collage 45 et une unité de mesure 2 externe. Ladite connexion électrique avec l'unité de mesure 2 externe étant réalisée au niveau de plots de test 47 disposés au niveau de l'interface de connexion 42.

Selon un mode de réalisation non représenté, il est possible que l'interface de connexion 42 soit disposée du côté de la face de collage FC40. Par exemple, les plots de test 47 peuvent être disposés sur une zone périphérique agencée autour des deuxièmes plots de collage 45, lesdites deuxièmes plots de collage 45 étant disposés sur une zone centrale de la face de collage FC40. Selon ce mode de réalisation, il peut être avantageux de prévoir que le dispositif de test 40 présente un diamètre strictement plus grand qu'un diamètre du substrat fonctionnel 10. Ainsi, il est possible de délimiter la zone centrale sur la face de collage FC40 du dispositif de test 40 qui a une aire sensiblement égale à celle du substrat fonctionnel 10, et de délimiter autour de cette zone centrale, la zone périphérique incluant l'interface de connexion 42. Ainsi, il est possible de reprendre le contact électrique sur les plots de test 47, au niveau de la face de collage FC40 directement, et à l'extérieur de la zone centrale de la face de collage FC40 au niveau de laquelle est réalisée le collage.

Selon un autre mode de réalisation, représenté sur les figures 1 et 2, l'interface de connexion 42 est disposée sur une face de test FT40 opposée à la face de collage FC40. Dans ce cas, il peut être prévu que les éléments de liaison 43 traversent le support 41 entre les deuxièmes plots de collage 45, et les plots de test 47. Par exemple, les éléments de liaison 43 comprennent des TSV, de l'anglais Through Silicon Vias. Ainsi, la reprise de contact des éléments de liaison 43 est réalisée du côté opposé à celui au niveau duquel les deuxièmes plots de collage 45 sont destinés à être en contact avec les premiers plots de collage 13. La mise en œuvre du procédé de fabrication est ainsi plus facile.

Le procédé de test peut comprendre en outre, une étape de polissage E3, dans laquelle au moins une face choisie parmi la face avant FAV du substrat fonctionnel 10 et la face de collage FC40 du dispositif de test 40 est polie par polissage mécano-chimique. De manière avantageuse, l'étape de polissage E3 comprend le polissage mécanochimique à la fois de la face de collage FC40 du dispositif de test 40 et de la face avant FAV du substrat fonctionnel 10. Ainsi, l'efficacité du collage entre les premiers plots de collage 13 et les deuxièmes plots de collage 45 est maximisée lors de l'étape de collage E4. De cette manière, il est possible de s'assurer que les premiers ou deuxièmes plots de collage 13, 45 présentent une rugosité suffisamment faible pour améliorer le collage temporaire entre eux.

Une étape de collage E4 est ensuite mise en œuvre, dans laquelle la face de collage FC40 du dispositif de test 40 est mise en contact avec la face avant FAV du substrat fonctionnel 10, de sorte que, pour chaque dispositif microélectronique 11, une liaison par collage temporaire est formée entre un premier plot de collage 13 et un deuxième plot de collage 45, et généralement de sorte que la face de collage FC40 du dispositif de test 40 recouvre la face avant FAV du substrat fonctionnel 10 sur au moins 80% de ladite face avant FAV. De cette manière, il est possible d'utiliser un unique dispositif de test 40 pour réaliser des tests électriques sur une majorité ou une totalité des dispositifs microélectroniques 11, en une seule étape de test. Il est également possible que l'étape de collage E4 soit mise en œuvre par un recouvrement total de la face avant FAV du substrat fonctionnel 10 par la face de collage FC40 du dispositif de test 40. En d'autres termes, l'étape de collage E4 est mise en œuvre à l'échelle de la plaque entière, ce qui permet de réaliser des tests (par exemple lors d'une étape de mesure E5 décrite ci-après) à l'échelle de la plaque entière, en une seule étape de mesure R5. II est par ailleurs possible de garantir que la totalité des dispositifs microélectroniques 11 sont collés à la face de collage FC40, ce qui permet de maximiser le nombre de dispositifs microélectroniques 11 testés.

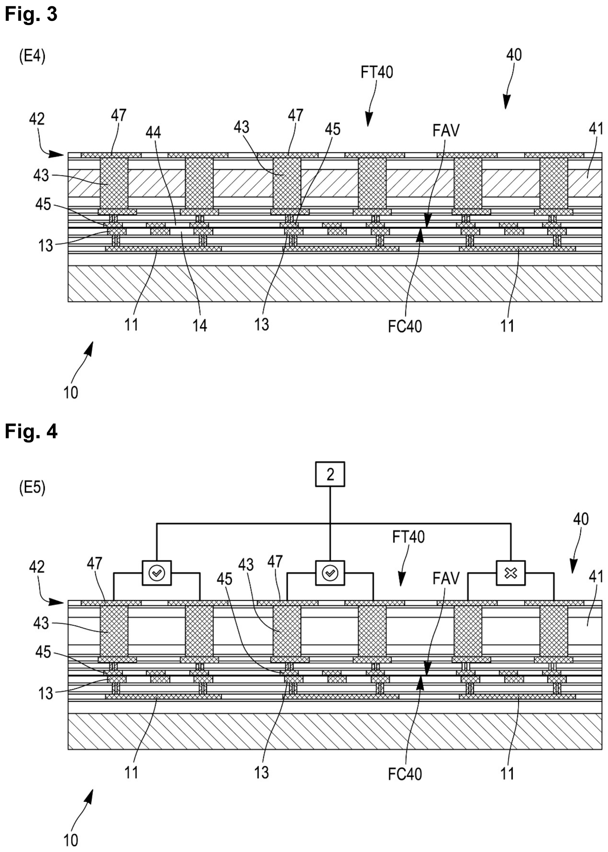

Selon une première variante illustrée sur la figure 3, l'étape de collage E4 est mise en œuvre par un collage hybride entre les premiers plots de collage 13 et les deuxièmes plots de collage 45. Un collage est généralement également réalisé entre la couche diélectrique 14, et la matrice diélectrique 44. De cette manière, il est possible de réaliser simplement l'étape de collage E4, ce qui est particulièrement adapté pour un procédé de test mis en œuvre dans un procédé de fabrication de dispositifs microélectroniques.

Par « collage hybride », on entend la formation d'une liaison spontanée et directe entre deux surfaces polies comprenant chacune au moins un plot métallique par exemple en cuivre, entouré par une couche de matériau diélectrique par exemple un oxyde de silicium. En effet, le collage hybride en microélectronique est une technique d'intégration 3D permettant l'assemblage direct de composants en mettant en contact deux surfaces hybrides composées d'un motif métallique intégré dans une matrice diélectrique par exemple un motif en cuivre (Cu) intégré dans une matrice d'oxyde de silicium (SiO₂). Après polissage et alignement, ces surfaces sont alignées et mises en contact pour former un collage simultané métal-métal et diélectrique-diélectrique, assurant une tenue mécanique et une connexion électrique.

Par exemple, la mise en œuvre d'un collage hybride peut résulter des étapes suivantes :
- la mise à disposition de deux surfaces comprenant au moins un plot métallique par exemple en cuivre, entouré par une couche de matériau diélectrique par exemple un oxyde de silicium, ce qui peut correspondre aux étapes de mise à disposition E1 et de fourniture E2 du procédé de test.
- le polissage de chacune des surfaces pour obtenir une rugosité faible, par exemple inférieure à 1 nm RMS. Par exemple, à l'issue de ce polissage, le premier plot de collage 13 est en retrait de la couche diélectrique 14, et le deuxième plot de collage 45 est en retrait de la matrice diélectrique 44, ce qui peut correspondre à l'étape de polissage E3 du procédé de test ; et
- la mise en contact des deux surfaces de sorte que les couches de matériau diélectrique de chaque surface entrent en contact l'une de l'autre.
- optionnellement, un chauffage des deux surfaces peut être mis en œuvre de sorte que les couches de matériau diélectrique se contractent et que les plots métalliques se dilatent. Par exemple, à l'issue de ce chauffage, les plots métalliques de chacune des deux surfaces se retrouvent comprimés l'un contre l'autre, formant ainsi le collage hybride entre les deux plots métalliques.

Selon un autre mode de réalisation, l'étape de collage E4 peut être mise en œuvre par liaison directe hydrophile entre les premiers plots de collage 13 et les deuxièmes plots de collage 45 uniquement. Par « liaison directe hydrophile entre les premiers plots de collage 13 et les deuxièmes plots de collage 45 uniquement », on entend la formation d'une liaison spontanée et directe entre deux surfaces polies comprenant chacune au moins un plot métallique, par exemple en niobium, entouré par de l'air. Par exemple, la mise en œuvre d'une telle liaison directe hydrophile an l'absence d'une couche de matériau diélectrique est décrite dans le document Candice Thomas et al 2025 Mater. Quantum. Technol. 5 016001*,* ou dans le document *Pablo Renaud et al. DOI: 10.1109*/*ECTC51529.2024.00076.* De cette manière, il est possible de réaliser simplement l'étape de collage E4 selon une deuxième alternative particulièrement adaptée pour un procédé de test mis en œuvre dans un procédé de fabrication de dispositifs microélectroniques.

Le procédé de test comprend ensuite l'étape de mesure E5, dans laquelle l'unité de mesure 2 détermine, pour chaque dispositif microélectronique 11, un état de fonctionnement. Cette étape de mesure E5 est mise en œuvre par l'application d'un courant ou d'une tension électrique à chaque premier plot de collage 13, par l'intermédiaire du deuxième plot de collage 45 avec lequel ledit premier plot de collage 13 est en contact, et du plot de test 47 correspondant.

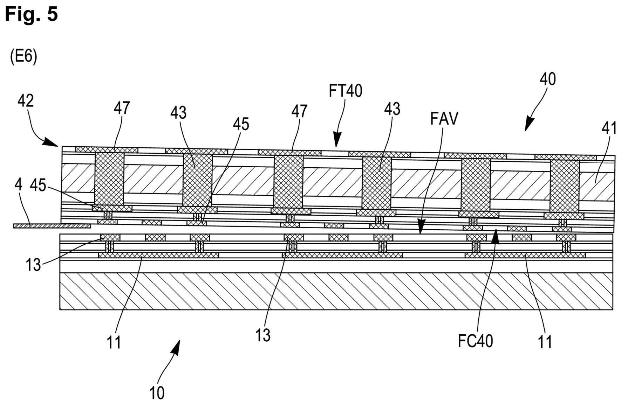

Comme on peut le voir sur la figure 5, l'unité de mesure 2 est connectée aux plots de test 47, et peut appliquer une tension électrique ou un courant électrique aux plots de test 47. Cette tension ou ce courant est ensuite transmis aux bornes des dispositifs microélectroniques 11 à tester, par l'intermédiaire des éléments de liaison 43, puis par l'intermédiaire des deuxièmes plots de collage 45, et enfin, par l'intermédiaire des premiers plots de collage 13. L'unité de mesure 2 peut ainsi déterminer si les dispositifs microélectroniques 11 sont fonctionnels ou non. Dans l'exemple illustré sur la figure 4, lors de l'étape de mesure E5, l'unité de mesure 2 a déterminé que les deux dispositifs microélectroniques 11 disposés à gauche sont fonctionnels et que le dispositif microélectronique 11 disposé à droite est défectueux.

Enfin, le procédé de test comprend une étape de détachement E6, dans laquelle une fine lame 4 est introduite entre la face avant FAV du substrat fonctionnel 10 et la face de collage FC40 du dispositif de test 40, de manière à rompre la liaison formée entre les premiers plots de collage 13 et les deuxièmes plots de collage 45 lors de l'étape de collage E4. De manière générale, par « fine lame 4 », on entend une lame présentant une épaisseur négligeable par rapport à sa longueur et la largeur, et dans le cas de la présente invention, que cette épaisseur est comprise entre 0,1 mm et 1,0 mm. De cette manière, il est possible de retirer le dispositif de test 40 du contact du substrat fonctionnel 10, pour mettre en œuvre des éventuelles étapes ultérieure de fabrication, comprenant le substrat fonctionnel 10. De manière générale, il est préférable que l'étape de détachement E6 soit mise en œuvre au maximum un mois après la mise en oeuvre de l'étape de collage E4, pour éviter que le collage ne devienne irréversible.

L'ensemble des dispositions précédemment décrites permettent de proposer un procédé de test permettant de tester unitairement une pluralité de dispositifs microélectroniques 11 disposés sur un substrat fonctionnel 10, lors d'une unique étape de mesure E5. L'utilisation d'un dispositif de test 40 dédié au substrat fonctionnel 10 à tester permet de réaliser la reprise de contact par collage temporaire, ce qui limite l'endommagement des premiers plots de collage 13.

## Revendications

1. Procédé de test pour tester des dispositifs microélectroniques (11), le procédé de test comprenant :
- une étape de mise à disposition (E1) d'un substrat fonctionnel (10) présentant une face avant (FAV), le substrat fonctionnel (10) comprenant en outre les dispositifs microélectroniques (11) agencés du côté de ladite face avant (FAV), chaque dispositif microélectronique (11) présentant au moins un premier plot de collage (13) tourné du côté de la face avant (FAV), les premiers plots de collage (13) étant agencés sur la face avant (FAV) selon un premier agencement ordonné ;
- une étape de fourniture (E2) d'un dispositif de test (40) présentant une face de collage (FC40), le dispositif de test (40) comprenant des deuxièmes plots de collage (45) agencés sur la face de collage (FC40) selon un deuxième agencement ordonné, ledit deuxième agencement ordonné comprenant au moins une portion qui correspond au premier agencement ordonné, le dispositif de test (40) comprenant en outre des éléments de liaison (43) électriquement conducteurs, lesdits éléments de liaison (43) étant configurés pour assurer une connexion électrique entre chaque deuxième plot de collage (45) et des plots de test (47) ;
- une étape de collage (E4), dans laquelle la face de collage (FC40) du dispositif de test (40) est mise en contact avec la face avant (FAV) du substrat fonctionnel (10), de sorte que, pour chaque dispositif microélectronique (11), une liaison par collage temporaire est formée entre un premier plot de collage (13) et un deuxième plot de collage (45) ;
- une étape de mesure (E5), dans laquelle une unité de mesure (2) détermine, pour chaque dispositif microélectronique (11), un état de fonctionnement, ladite étape de mesure (E5) étant mise en œuvre par l'application d'un courant ou d'une tension électrique à chaque premier plot de collage (13), par l'intermédiaire du deuxième plot de collage (45) avec lequel ledit premier plot de collage (13) est en contact, et du plot de test (47) correspondant ; et
- une étape de détachement (E6), dans laquelle une fine lame (4) est introduite entre la face avant (FAV) du substrat fonctionnel (10) et la face de collage (FC40) du dispositif de test (40), de manière à rompre la liaison formée entre les premiers plots de collage (13) et les deuxièmes plots de collage (45) lors de l'étape de collage (E4).

2. Procédé de test selon la revendication 1, comprenant en outre, une étape de polissage (E3) mise en œuvre avant l'étape de collage (E4), dans laquelle au moins une face choisie parmi la face avant (FAV) du substrat fonctionnel (10) et la face de collage (FC40) du dispositif de test (40) est polie par polissage mécano-chimique.

3. Procédé de test selon la revendication 2, dans lequel l'étape de collage (E4) est mise en œuvre par un collage hybride entre les premiers plots de collage (13) et les deuxièmes plots de collage (45).

4. Procédé de test selon la revendication 2, dans lequel l'étape de collage (E4) est mise en œuvre par liaison directe hydrophile entre les premiers plots de collage (13) et les deuxièmes plots de collage (45) uniquement.

5. Procédé de test selon l'une quelconque des revendications 1 à 4, dans lequel lors de l'étape de mise à disposition (E1), l'agencement des premiers plots de collage (13) selon le premier agencement ordonné est réalisé par photolithographie au moyen d'un masque de fabrication, et dans lequel lors de l'étape de fourniture (E2) du dispositif de test (40), l'agencement des deuxièmes plots de collage (45) selon le deuxième agencement ordonné est réalisé par photolithographie au moyen dudit masque de fabrication.

6. Procédé de test selon l'une quelconque des revendications 1 à 5, dans lequel l'étape de collage (E4) est mise en œuvre de sorte que la face de collage (FC40) du dispositif de test (40) recouvre la face avant (FAV) du substrat fonctionnel (10) sur au moins 80% de ladite face avant (FAV).

7. Procédé de test selon la revendication 6, dans lequel la face avant (FAV) du substrat fonctionnel (10) présente une forme de disque présentant un premier rayon, et dans lequel la face de collage (FC40) du dispositif de test (40) présente une forme de disque présentant un deuxième rayon égal au premier rayon, l'étape de collage (E4) étant alors mise en œuvre par un recouvrement total de la face avant (FAV) du substrat fonctionnel (10) par la face de collage (FC40) du dispositif de test (40).
